Europäisches Patentamt

European Patent Office

Office européen des brevets

(11) Publication number: **0 378 392**
**A1**

## EUROPEAN PATENT APPLICATION

(21) Application number: **90300284.8**

(22) Date of filing: **10.01.90**

(51) Int. Cl.⁵: **H05K 9/00**

(30) Priority: **12.01.89 JP 3748/89**

(43) Date of publication of application:
**18.07.90 Bulletin 90/29**

(84) Designated Contracting States:
**DE FR GB**

(71) Applicant: **KABUSHIKI KAISHA TOSHIBA**
**72, Horikawa-cho Saiwai-ku**
**Kawasaki-shi Kanagawa-ken 210(JP)**

(72) Inventor: **Shimizu, Hisashi Intellectual**
**Property Division**
**Toshiba Corporation 1-1 Shibaura 1-chome**
**Minato-ku Tokyo(JP)**
Inventor: **Ito, Ikuo Intellectual Property**
**Division**
**Toshiba Corporation 1-1 Shibaura 1-chome**
**Minato-ku Tokyo(JP)**

(74) Representative: **BATCHELLOR, KIRK & CO.**
**2 Pear Tree Court Farringdon Road**
**London EC1R 0DS(GB)**

(54) Casing for electronic apparatus.

(57) Electronic apparatus having a casing comprising a two part shell of conductive material, coated with insulating material, the two shells being connected by an electrically conductive screw, so as to shield the apparatus from electromagnetic radiation.

Fig.4.

## Casing for Electronic Apparatus

The present invention relates to electronic apparatus having a casing which comprises a pair of electrically connected conductive shells covered with insulating material.

Conventionally, a conductive casing is used for shielding electronic apparatus from interference caused by electromagnetic radiation (for example R.F.). To make the casing conductive, copper, stainless steel or the like in fibrous form is mixed in the material used for forming the casing, which is typically a resin material.

In electronic apparatus having a casing comprising top and bottom outer shells of the above type, therefore, simply assembling these two outer shells together cannot provide proper shielding as they are not electrically connected.

To electrically connect the two outer shells, the conventional method is to remove the resin material from the surfaces of the contacting portions of the outer covers. The resin material can be removed either by dissolving it using some chemical treatment or by cutting it away. Alternatively, the top and bottom outer shells may be electrically connected by means of connection terminals provided on these covers. The method of removing resin material from the already formed portions of the outer cover, however, takes a significant time and is likely to deteriorate the appearance of the apparatus. The alternative solution involving the connection terminals requires some extra space for attaching such terminals and is thus an obstacle which prevents the apparatus being made more compact.

Accordingly, the present invention provides a casing for electronic apparatus comprising at least two shells of conductive material coated with insulating material, and at least one connecting means of conductive material which is adapted to make an electrical connection between said shells.

One embodiment of the invention will now be described by way of example with reference to the accompanying drawings in which:

Figure 1 is a perspective view of one embodiment of the present invention; and

Figures 2 to 4 are cross-sectional views taken along the line A-A of Figure 1 and illustrating how the first and second outer covers are connected.

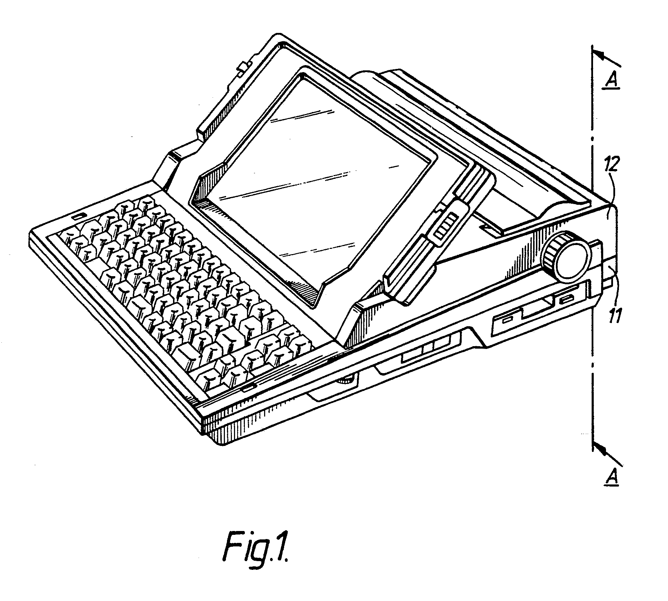

Referring to Figure 1, the apparatus comprises a first outer shell 11 and a second outer shell 12. These shells 11 and 12 form a casing which protects electronic parts disposed in the electronic apparatus, such as a printed circuit board and connector cables.

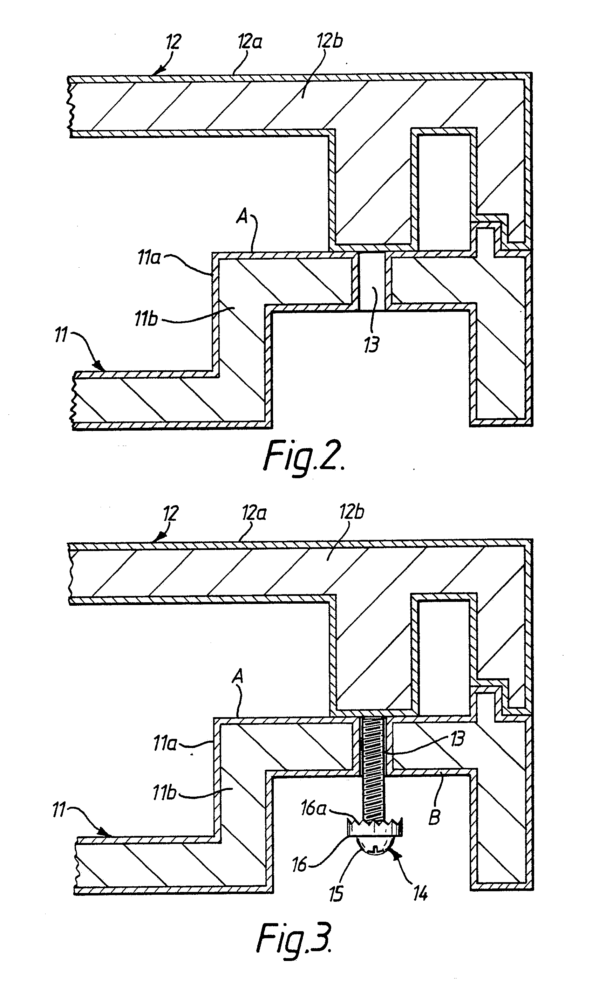

Figures 2 through 4 are cross-sectional views taken along the line A-A in Figure 1, which illustrate how the first and second outer shells 11 and 12 are connected. Referring to Figure 2, the first outer shell 11 is made by covering the surface of a first conductive shell 11b with an insulating material; the first conductor has a through hole 13 formed therein. The second outer shell 12, disposed in contact with the through hole 13 of the first outer cover 11 (on the side of the surface A in the diagram), is made by covering the surface of a second conductor 12b with a second insulator 12a. The first and second conductors 11b and 12b are formed by mixing copper, stainless steel or the like in a fiber form in a resin material or the like, so that they become conductive. The first and second insulators 11a and 12a are formed by a resin material or the like.

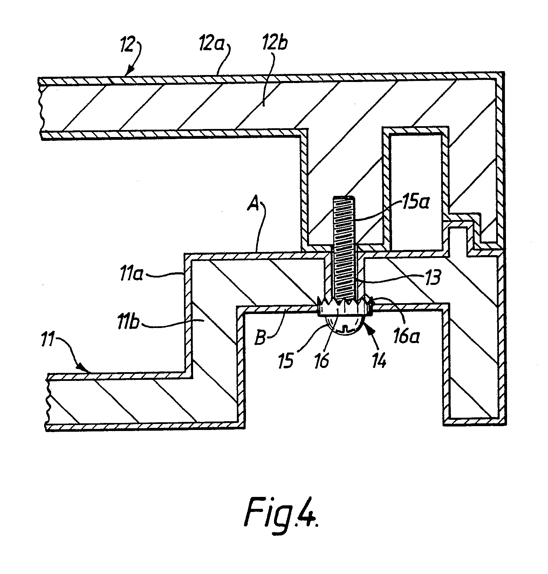

A description will now be given of how to electrically connect the first and second outer covers 11 and 12. Figure 3 illustrates joining means 14 being inserted in the through hole 13 and Figure 4 illustrates the joining means being screwed into the second conductor 12b. Referring to Figure 3, the joining means 14 comprises a screw 15 and a washer 16. The screw 15 is adapted to be inserted in the through hole 13 of the first outer cover 11 to come in contact with the second insulator 12a of the second outer cover 12. The washer 16 has a plurality of projections 16a formed on one surface which comes in contact with the first insulator 11a (on the side of the surface B in the diagram) around the peripheral portion of the through hole 13. The screw 15 penetrates the washer 16.

The operation of the present invention will now be described.

As shown in Figure 4, the screw 15 inserted in the through hole 13 of the first outer cover 11 is tightened. As a free or distal end 15a of the screw 15 is driven into the second conductor 12b of the second outer cover 12, the projections 16a formed on one surface of the washer 16 cut into the first insulator 11a of the first outer cover 11 around the through hole 13 (on the side of the surface B) in Figure 4). Further tightening the screw 15 enforces those projections 16a of the washer 16 to penetrate the first insulator 11a and cut into the first conductor 11b. This electrically connects the first and second conductors 11b and 12b through the screw 15 and washer 16.

Through the above assembling, the first and second outer covers 11 and 12 form an electromagnetically-shielded casing.

Although the foregoing description has been given with reference to the method of electrically connecting the first and second outer covers 11 and 12 by means of a separate screw 15 and washer 16, the screw 15 and washer 16 may alternatively be formed integrally so as to eliminate the operation of assembling the screw 15 and washer 16 together when the first and second outer covers 11 and 12 are put together.

## Claims

1. A casing for electronic apparatus comprising at least two shells (11, 12) of conductive material coated with insulating material (11a, 12a), and at least one connecting means (14) of conductive material which is adapted to make an electrical connection between said shells.

2. A casing for electronic apparatus including a pair of insulating film coated shells, said casing comprising:
a first outer shell (11) comprising a first conductor (11b) covered with insulating material 11a and having a through hole (13) formed therein;
a second outer shell (12) adapted for attachment to said first outer shell (11) and comprising a second conductor (12b) covered with insulating material (12a); and
conductive connecting means (14) adapted to be inserted in said through hole (13) so as to penetrate said first insulator (11a) around said through hole (13) and to make an electrical connection to said second conductor (12b) and to be inserted into an aperture in said second conductor (12b).

3. A casing according to claim 1, or claim 2 wherein said connecting means comprises a bolt having a toothed washer or lock washer adapted to penetrate said insulating material.

4. Electronic apparatus having a casing according to any preceding claim.

Fig.1.

EP 0 378 392 A1

Fig.2.

Fig.3.

Fig.4.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| Y | DE-A-2826092 (OLYMPUS OPTICAL CO.)<br>* page 4, paragraph 2; figure 3 *<br>--- | 1-2 | H05K9/00 |
| Y | DE-A-3313970 (SIEMENS AG)<br>* the whole document *<br>--- | 1-2 | |
| A | EP-A-0262794 (THE MARCONI COMPANY LIMITED)<br>* column 2, lines 12 - 46 *<br>----- | 1 | |
| | | | **TECHNICAL FIELDS SEARCHED (Int. Cl.5 )**<br><br>H05K<br>G06F |

The present search report has been drawn up for all claims

| Place of search | Date of completion of the search | Examiner |
|---|---|---|
| THE HAGUE | 30 MARCH 1990 | TOUSSAINT F.M.A. |